Europäisches Patentamt

European Patent Office    (11) Veröffentlichungsnummer:    **0 065 154**
Office européen des brevets                               A2

(19)

(12) **EUROPÄISCHE PATENTANMELDUNG**

(21) Anmeldenummer: 82103672.0          (51) Int. Cl.³: **H 05 K 1/18,** H 05 K 1/00

(22) Anmeldetag: 29.04.82

(30) Priorität: **20.05.81 DE 3119952**          �copyright Anmelder: **KRONE GmbH, Goerzallee 311,**
                                              **D-1000 Berlin 37 (DE)**

(43) Veröffentlichungstag der Anmeldung: **24.11.82**    (72) Erfinder: **Becker, Peter, Gilgestrasse 15,**
   **Patentblatt 82/47**                               **D-1000 Berlin 37 (DE)**

                                              (74) Vertreter: **Patentanwälte Beetz sen. - Beetz jun. Timpe -**
                                              **Siegfried - Schmitt-Fumian, Steinsdorfstrasse 10,**
(84) Benannte Vertragsstaaten: **AT BE CH FR IT LI LU NL SE**    **D-8000 München 22 (DE)**

(54) **Biegefreundliche Leiterplatte.**

㉗ Gegenstand der Erfindung ist eine entsprechend der
Kontur des Einbaugerätes gebogen ausgebildete Leiterplatte (1) aus dünnem Basismaterial, deren elektronische Bauelemente (2) vorzugsweise längs einer Richtung parallel zu
einer Biegeachse (3) ausgerichtet sind.
    Zur Vermeidung von Rißbildungen beim Biegen ist die
Leiterplatte (1) mit Lötstoplack überzogen.

Biegefreundliche Leiterplatte

Die vorliegende Erfindung betrifft eine Leiterplatte aus dünnem Basismaterial, die mit elektronischen Bauteilen bestückt ist, zum Einbau in räumlich begrenzte Geräte.

Es sind aus der Firmenschrift "Flexible gedruckte Schaltungen" der Firma Kabelwerke Reinshagen flexible gedruckte Schaltungen auf Folienbasis bekannt.

Die auf einer Folie (0,3 mm Dicke) aus einem speziellen Werkstoff befindlichen Leiterbahnen können gebogen und somit der jeweiligen Gebrauchslage angepaßt werden (Ersatz für Kabelbäume).

Ihr Nachteil besteht darin, daß die Folie nicht mit

125-x2177-TE

elektronischen Bauelementen bestückt werden kann.

Ferner sind Einrichtungen bekannt, bei denen zwei starre Leiterplatten durch eine auflaminierte flexible gedruckte Schaltung verbunden sind.

Ihr Nachteil ist, daß im auflaminierten flexiblen Bereich keine elektronischen Bauelemente bestückt und gelötet werden können.

Der Erfindung liegt die Aufgabe zugrunde, eine Leiterplatte zu entwickeln, die im herkömmlichen Verfahren mit elektronischen Bauelementen maschinell bestückbar und lötbar ist und danach - beim Einbau in das Gerät - der Kontur des Gerätes durch einen Biegevorgang angepaßt werden und damit die gewünschte Form erhalten kann.

Diese Aufgabe wird bei einer Leiterplatte der eingangs genannten Art erfindungsgemäß dadurch gelöst, daß eine aus einem herkömmlichen Basismaterial bestehende Leiterplatte entsprechend der Kontur des Einbau-Gerätes gebogen ausgebildet ist und daß alle auf ihr angeordneten Bauelemente (vorzugsweise) längs in einer zu einer Biegeachse parallelen Richtung ausgerichtet sind, wobei die Leiterbahnen zur Vermeidung von Rißbildungen beim Biegen der Leiterplatte mit Lötstoplack überzogen sind.

Eine vorteilhafte weitere Ausgestaltung der Erfindung ist im Unteranspruch gekennzeichnet.

Dadurch, daß die elektronischen Bauelemente parallel zu einer Biegeachse der Leiterplatte ausgerichtet sind, läßt sich die Leiterplatte trotz der Anbringung der Bauelemente entsprechend der Kontur des Einbaugerätes gut biegen, wobei der Lötstoplacküberzug der Leiterbahnen eine Rißbildung vermeidet.

Der Stirnseitenansatz der Leiterplatte zur Arretierung in einer Halterung des Einbau-Gerätes kann dabei die genaue Biegung der Leiterplatte erleichtern.

Ein Ausführungsbeispiel der Erfindung ist in der Zeichnung dargestellt; darin zeigen:

Fig. 1      den Einbau einer gebogenen Leiterplatte in einem Handapparat eines fernmeldetechnischen Gerätes, und

Fig. 2      die Anordnung der Bauelemente auf der Leiterplatte, wobei die gestrichelte Linie die Biegeachse andeutet.

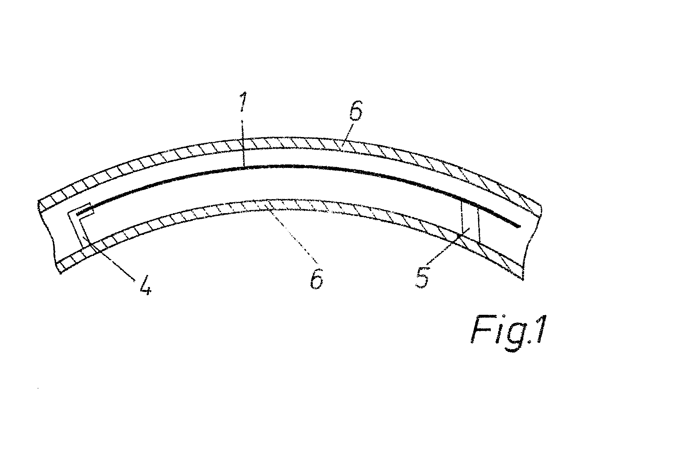

Wie die Fig. 1 zeigt, ist die Leiterplatte 1 im eingebauten Zustand gebogen.

Leiterplatten nach der Erfindung werden dort eingesetzt, wo plane Leiterplatten aufgrund der Gehäuseform wegen ihrer Abmessungen nicht verwendet werden können.

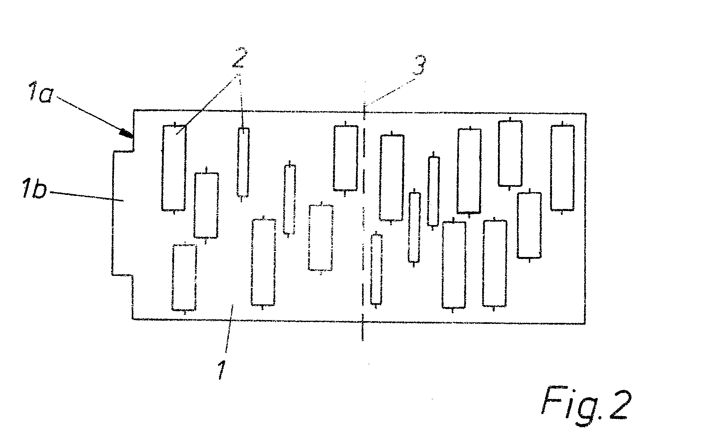

Die Leiterplatte 1 wird in dem in Fig. 1 und 2 dargestellten Ausführungsbeispiel am Sockel 5 im Einbau-Gehäuse 6 festgeschraubt und mit der einen Stirnseite 1a, an der sich ein Ansatz 1b zur Arretierung befindet, in die im Gehäuse 6 fest angeordnete Halterung 4 geklemmt, wodurch die Leiterplatte 1 elastisch gebogen und der Kontur des Gehäuses 6 angepaßt wird.

Für die Leiterplatte 1 ist kein spezielles Basismaterial notwendig.

Die Fig. 2 zeigt im einzelnen, daß die auf der Leiterplatte 1 angeordneten elektronischen Bauelemente 2 vorzugsweise längs in einer Richtung parallel zu einer gestrichelt dargestellten Biegeachse 3 ausgerichtet sind und daher eine Versteifung der Leiterplatte 1 durch die Bauelemente 2 vermieden wird. Ferner ist die Leiterplatte 1 mit (nicht dargestelltem) Lötstoplack überzogen, so daß diese überzogenen Leiterbahnen nicht verzinnt werden und eine Rißbildung beim Biegevorgang der Leiterplatte 1 verhindert wird.

- 1 -

0065154

Ansprüche
-------------------

1. Leiterplatte aus dünnem Basismaterial, die mit elektronischen Bauelementen bestückt ist, zum Einbau in räumlich begrenzte Geräte,

   dadurch gekennzeichnet,

   daß die aus einem herkömmlichen Basismaterial bestehende Leiterplatte (1) entsprechend der Kontur des Einbau-Gerätes (6) gebogen ausgebildet ist und daß alle auf ihr angeordneten elektronischen Bauelemente (2) längs einer zu einer Biegeachse (3) parallelen Richtung ausgerichtet sind, wobei die Leiterbahnen zur Vermeidung von Rißbildungen beim Biegen der Leiterplatte (1) mit Lötstoplack überzogen sind.

2. Leiterplatte nach Anspruch 1,
   dadurch gekennzeichnet,
   daß die Leiterplatte (1) an ihrer Stirnseite (1a) einen Ansatz (1b) zur Arretierung in einer Halterung (4) des Einbau-Gerätes (6) aufweist.

125-(x 2177)-TE

Fig.1

Fig.2